# FASCICULE DE BREVET EUROPEEN

(11) **EP 3 210 828 B1**
(45) Date de publication et mention de la délivrance du brevet: **17.07.2024**
(21) Numéro de dépôt: 17157334.8
(22) Date de dépôt: 22.02.2017
(51) Int. Cl.: B60Q 3/74, B60Q 3/80, H01L 33/24, H01L 33/38, F21Y 105/12, F21V 5/04, H01L 27/15, H01L 33/18

(54) **SYSTEME D'ECLAIRAGE POUR L'HABITACLE D'UN VEHICULE AUTOMOBILE**
BELEUCHTUNGSSYSTEM FÜR DEN FAHRZEUGINNENRAUM EINES KRAFTFAHRZEUGS
LIGHTING SYSTEM FOR THE PASSENGER COMPARTMENT OF A MOTOR VEHICLE

(30) Priorité: 24.02.2016 FR 1651523
(43) Date de publication de la demande: 30.08.2017
(73) Titulaire: Valeo Vision, 93012 Bobigny Cedex (FR)
(72) Inventeur: BRIAND, Gilles, 06250 MOUGINS (FR); ALBOU, Pierre, 75013 PARIS (FR)
(74) Mandataire: Valeo Visibility

(56) Documents cités:
- EP-A2- 2 923 891
- EP-B1- 0 921 568
- WO-A1-2010/014032
- WO-A1-2013/102996
- WO-A2-2006/042050
- FR-A1- 3 011 388
- GB-A- 2 473 311
- US-A1- 2003 133 307
- US-A1- 2003 174 499
- US-A1- 2007 091 634
- US-A1- 2011 204 327
- US-A1- 2011 279 039
- US-A1- 2015 243 853
- US-A1- 2015 298 607

## Description

La présente invention concerne un système d'éclairage pour l'habitacle d'un véhicule automobile.

Les documents GB 2 473 311 A, WO 2010/014032 A1 et US 2015/243853 A1 décrivent des systèmes d'éclairage connus.

Dans le domaine de l'éclairage pour habitacle de véhicule automobile, il est connu de longue date de munir l'habitacle d'un véhicule automobile d'un éclairage d'ambiance ou de liseuses. L'éclairage provient généralement de modules distincts, dédiés à chacune des fonctions.

Pour les liseuses, il est connu de les munir de lentilles mobiles permettant de diriger le faisceau lumineux en différents endroits du véhicule, voire de changer la taille de la plage éclairée. Cela permet de ne pas multiplier leur nombre. Cependant, l'utilisation de pièces mobiles confère à ces modules une certaine complexité. Il a également été proposé des liseuses formées d'un guide de lumière dont différentes portions sont allumées en fonction de la zone que l'on souhaite éclairer. Cependant, elles nécessitent une source lumineuse distincte pour chaque zone. En outre, ces différentes solutions n'assurent que la fonction liseuse de sorte qu'un ou des modules complémentaires doivent être employés pour assurer la fonction d'éclairage d'ambiance.

Il est encore connu des modules regroupant différentes lampes à incandescence ou halogènes, offrant à la fois un éclairage d'ambiance et un éclairage en mode liseuse, éventuellement dans différentes directions. Cependant ces modules font appel à de nombreuses lampes pour assurer les différentes fonctions d'éclairage souhaitées et offrent de la sorte un niveau d'intégration limité. La qualité de l'éclairage produit reste également faible.

L'invention a pour objectif de pallier au moins partiellement les inconvénients évoqués plus haut et propose à cette fin un système d'éclairage tel que défini dans la revendication 1. Il comprend des sources lumineuses électroluminescentes à semi-conducteur et un substrat de croissance desdites sources lumineuses, lesdites sources lumineuses étant réparties sur ledit substrat pour définir une pluralité de zones émettrices de lumière, ledit système étant configuré pour activer la ou les sources lumineuses d'une même zone indépendamment d'une zone à l'autre, ladite pluralité de zones étant configurée pour émettre des faisceaux destinés à produire un éclairage différent d'une zone à l'autre.

Grâce à l'invention, on obtient un haut degré d'intégration. En effet, on utilise les sources lumineuses issues d'un seul et même substrat pour assurer les différentes fonctions d'éclairage souhaitées, telle qu'une fonction d'éclairage d'ambiance et/ou de liseuse.

Un tel résultat est en outre obtenu sans avoir recours à des pièces mobiles. En effet, l'étendu que l'on peut donner au substrat permet d'implanter des sources lumineuses permettant d'éclairer des zones distantes l'une de l'autre.

L'utilisation de sources électroluminescentes à semi-conducteur permet en outre de disposer de nouveaux effets d'éclairage par rapport aux lampes à incandescence et/ou halogènes des modules connus.

Des caractéristiques complémentaires de l'invention, qui pourront être considérées seules ou en combinaison suivent :
- ledit système est configuré pour alimenter en courant la ou les sources lumineuses d'une même zone indépendamment d'une autre desdites zones,
- ledit système est configuré pour que la ou les sources lumineuses d'au moins une même zone soient alimentées sélectivement avec au moins deux courants électriques d'intensité différente,
- les bâtonnets, présentent une configuration différente d'une zone à l'autre,
- ledit substrat est une couche de matériau, notamment de Si,
- l'une au moins desdites zones comprend un convertisseur de longueur d'onde,
- ledit système comprend une unité de commande, configurée pour contrôler, en particulier sélectivement, l'alimentation en courant desdites zones,
- ladite unité de commande est configurée pour alimenter lesdites zones selon un courant différent d'une zone à l'autre,
- ladite unité de commande est configurée pour alimenter une même desdites zones selon des courants différents,
- au moins une partie de l'unité de commande est empilée sous le substrat de manière à connecter électriquement ladite unité de commande audit substrat,
- ladite unité de commande comprend une carte à circuits imprimés,
- ladite carte est disposée sur une face dudit substrat opposée à une face portant lesdites sources lumineuses,
- ladite unité de commande est configurée pour alimenter tout ou partie desdites zones de façon à obtenir un éclairage d'ambiance,
- ladite unité de commande est configurée pour alimenter au moins l'une des zones de façon à obtenir un éclairage en mode liseuse,
- ladite unité de commande est configurée pour alimenter au moins l'une des zones de façon à obtenir un éclairage d'ambiance et au moins une autre des zones pour obtenir un éclairage en mode liseuse,
- ledit système comprend en outre des sources configurées pour émettre des rayons présentant une longueur d'onde dans un domaine non-visible, en particulier l'infrarouge et/ou l'ultraviolet,
- lesdites sources configurées pour émettre des rayons présentant une longueur d'onde dans un domaine non-visible sont disposées sur ledit substrat,
- lesdites sources lumineuses configurées pour émettre des rayons présentant une longueur d'onde dans un domaine non-visible comprennent des bâtonnets électroluminescents munis d'au moins un convertisseur de longueur d'onde,
- lesdits bâtonnets des sources lumineuses configurées pour émettre des rayons présentant une longueur d'onde dans un domaine non-visible sont issus dudit substrat,
- ledit système comprend en outre une unité de suivi des occupants du véhicule, configurée pour exploiter des informations recueillies à l'aide des rayons émis par la ou lesdites sources émettant des rayons présentant une longueur d'onde dans le domaine non-visible,
- ledit système comprend en outre une optique de mise en forme,
- ladite optique de mise en forme comprend une ou plusieurs lentilles focalisées pour générer un faisceau d'ouverture réduite et/ou une ou plusieurs lentilles grand angle,
- ladite optique de mise en forme est directement en contact avec lesdites sources lumineuses, en particulier avec une extrémité distale desdits bâtonnets.

D'autres avantages et caractéristiques de l'invention apparaîtront à la lecture de la description suivante, donnée uniquement à titre d'exemple non limitatif, et faite en référence aux dessins annexés parmi lesquels :
- - la figure 1 illustre de façon schématique, en vue de côté, un mode de réalisation du système d'éclairage conforme à l'invention,
- - la figure 2 illustre de façon schématique, en vue de faces, les zones émettrices de lumière d'un mode de réalisation d'un système d'éclairage conforme à l'invention.

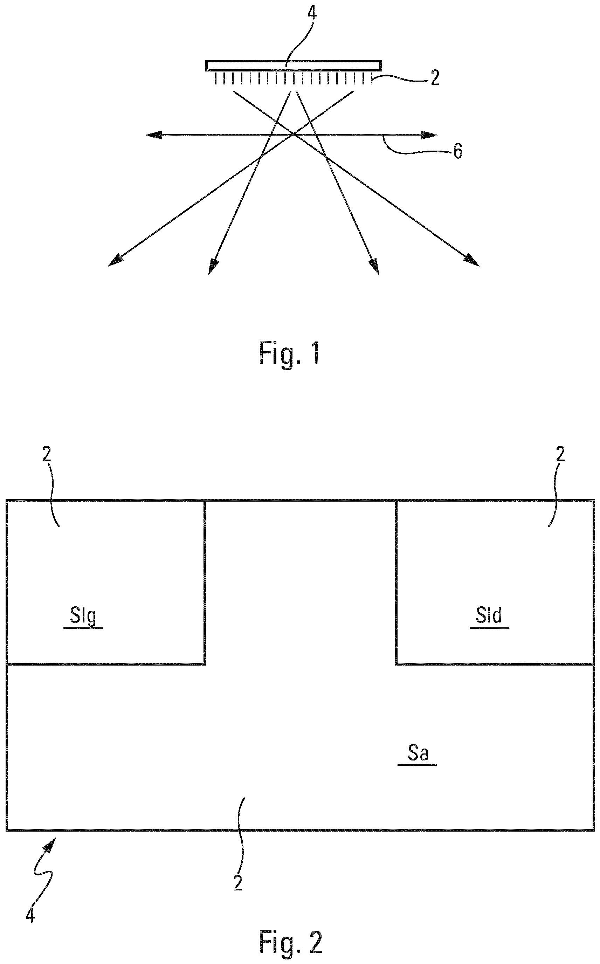

Comme illustré à la figure 1, l'invention concerne un système d'éclairage pour habitacle de véhicule automobile. Elle est avantageusement configurée pour être intégrée dans un élément d'habillage intérieur d'habitacle de véhicule tel qu'un plafonnier, un module multifonctions de pare-brise ou autres.

Ledit système comprend des sources lumineuses électroluminescentes 2 à semi-conducteur et un substrat 4 de croissance desdites sources lumineuses 2. Lesdites sources lumineuses 2 sont configurées sous la forme des bâtonnets électroluminescents de dimensions submillimétriques, chaque bâtonnet 2 étant ici symbolisé par un trait. Lesdits bâtonnets s'étendent à partir dudit substrat 4 qui pourra être une couche de matériau, notamment de Si.

Lesdits bâtonnets 2 présentent une structure en couches concentriques, notamment en couches de GaN avec interposition de puits quantiques, lesdites couches étant générées depuis ledit substrat 4. La nature et la disposition des couches permettent l'émission de photons tout le long des bâtonnets.

Ledit substrat 4 et lesdits bâtonnets 2 sont formés par une puce ou, dans un mode de réalisation qui n'est pas selon l'invention, par plusieurs puces. A titre d'exemple, dans les puces connues utilisant une telle technologie, lesdits bâtonnets 4 présentent un diamètre de moins d'un micron pour une hauteur d'environ 2,5 microns et sont espacés entre eux sur le substrat 4 d'une distance de l'ordre de 10 à 50 microns. Lesdites puces sont, notamment, de forme rectangulaire et les dimensions de leurs côtés sont de l'ordre du centimètre.

Comme illustré à la figure 2, lesdites sources lumineuses sont réparties sur ledit substrat pour définir une pluralité de zones émettrices de lumière Sa, Slg, Sld. De plus, ledit système est configuré pour activer la ou les sources lumineuses d'une même zone indépendamment d'une zone à l'autre, ladite pluralité de zones Sa, Slg, Sld étant configurée pour émettre des faisceaux destinés à produire un éclairage différent d'une zone à l'autre. Ledit système pourra, par exemple, fournir un éclairage général et/ou local dans l'habitacle du véhicule, à l'avant, à l'arrière et/ou pour chaque passager. Il pourra s'agir, notamment, d'un éclairage d'ambiance, d'un éclairage du type liseuse et/ou d'un éclairage de points ou composants spécifique du véhicule, tels que boîte à gants, passage de porte et/ou commandes.

Ici, ledit système comprend une surface émettrice de lumière sensiblement rectangulaire partagée en trois zones émettrices de lumière Sa, Slg, Sld au sens de l'invention. Deux desdites zones émettrices Slg, Sld sont destinées à former des liseuses. Elles sont respectivement situées, sur la figure, dans les coins supérieurs gauche et droit. Le reste de la surface émettrice, sensiblement en forme de T inversé, définit la troisième zone émettrice. Elle est destinée à produire un éclairage d'ambiance. Naturellement, une telle configuration n'est pas limitative, ni en termes de forme de la surface ou des zones émettrices, de nombre de zones émettrices, de positionnement relatifs desdites zones émettrices, de nature de l'éclairage destiné à être fourni par chacune desdites zones émettrices, ni encore en termes d'aucun autre paramètre tant qu'au moins deux desdites zones émettrices pourront fournir un éclairage de type différent d'une zone à l'autre.

De la sorte, avec un haut degré d'intégration et sans avoir recours à des pièces mobiles, l'invention permet d'assurer les différentes fonctions d'éclairage souhaitées.

Pour cela, selon une première variante, lesdites sources lumineuses 2, en particulier lesdits bâtonnets, présentent une configuration différente d'une zone à l'autre. Lesdits bâtonnets pourront présenter, conformément à une variante de la présente invention, une densité d'implantation sur le substrat 4 différente d'une zone à l'autre.

La densité de bâtonnets pourra, par exemple, être plus faible dans la ou les zones Sa destinées à fournir un éclairage d'ambiance et plus importante dans la ou les zones Slg, Sld, destinées à fournisseur un éclairage du type liseuse. Sur la figure 2, la densité de points dans la zone Sa est plus faible que la densité de points dans les zones Slg et Sld. Un exemple de densité pour une zone destiné à assurer un éclairage de type liseuse pourra correspondre, par exemple, à une distance d'environ 30 microns entre chaque bâtonnet.

Ledit système pourra encore comprendre un ou une pluralité de convertisseur de longueur d'onde permettant de changer la couleur émise par lesdites sources lumineuses, au moins pour certaines des zones, notamment des zones d'éclairage de composants du véhicule. Autrement dit, l'une au moins desdites zones pourra comprendre un convertisseur de longueur d'onde. On entend par convertisseur de longueur d'onde un convertisseur de lumière comprenant au moins un matériau luminescent conçu pour absorber au moins une partie d'au moins une lumière d'excitation émise par une source lumineuse et pour convertir au moins une partie de ladite lumière d'excitation absorbée en une lumière d'émission ayant une longueur d'onde différente de celle de la lumière d'excitation. A titre d'exemple, pour émettre une lumière blanche, on utilisera des bâtonnets émetteurs de lumière bleu ou UV avec un convertisseur de lumière pour obtenir par synthèse additive la lumière blanche.

Pour ce qui est de l'activation desdites zones Sa, Sig, Sld, ledit système est, par exemple, configuré pour alimenter en courant la ou les sources lumineuse d'une même zone indépendamment d'une autre desdites zones. A l'intérieur de chaque zone, la ou les puces d'une même zone sont alimentées en parallèle. Dans le cas où une même puce comprend plusieurs zones émettrices, la puce est alors alimentée de façon distincte pour chaque zone.

Avantageusement, ledit système est configuré pour que la ou les sources lumineuses d'au moins une même zone soient alimentées sélectivement avec au moins deux courants électriques d'intensité différente. Selon ce mode de fonctionnement, on dispose d'une variante de mise en oeuvre de l'invention qui pourra se substituer ou se combiner avec la première variante exposée plus haut, basée sur la densité de bâtonnets.

Ledit système comprend, par exemple, une unité de commande, non illustrée, configurée pour contrôler sélectivement l'alimentation en courant desdites zones, voire le niveau de courant envoyé pour alimenter chacune des zones. En d'autres termes, ladite unité de commande unité de commande pourra être configurée pour alimenter ou non lesdites zones selon les ordres d'activation reçus. Avantageusement, ladite unité de commande pourra en outre être configurée pour alimenter une même desdites zones selon des niveaux de courant différents. On peut ainsi disposer de différents effets de lumière pour une même zone, voire donner à une zone une fonction d'éclairage identique à celle d'une autre zone, notamment une zone voisine, par exemple pour augmenter la taille de surface émettrice dédiée à une fonction lumineuse donnée. A titre d'exemple, en limitant leur courant d'alimentation, les surfaces Sld et Slg pourront être utilisée pour diffuser un éclairage d'ambiance, au lieu d'un éclairage du type liseuse, pour compléter l'éclairage d'ambiance fourni par la zone Sa.

Autrement dit, ladite unité de commande est configurée :
- pour alimenter tout ou partie desdites zones de façon à obtenir un éclairage d'ambiance, et/ou
- pour alimenter au moins l'une des zones de façon à obtenir un éclairage en mode liseuse, et/ou
- pour alimenter au moins l'une des zones de façon à obtenir un éclairage d'ambiance et au moins une autre des zones pour obtenir un éclairage en mode liseuse.

Ladite unité de commande comprend, notamment, une carte à circuits imprimés. Ladite carte pourra être disposée sur une face dudit substrat opposée à une face portant lesdites sources lumineuses 2. Autrement dit, au moins une partie de l'unité de commande, ici ladite carte à circuit imprimés, est empilée sous le substrat de manière à connecter électriquement ladite unité de commande audit substrat. Ladite carte à circuits imprimés est, par exemple, une carte à circuits imprimés, notamment du type PCB (« Printed Circuit Board »), et/ou une carte de circuits imprimés flexible, notamment du type FPCB (« Flexible Printed Circuit Board »), et/ou un dispositif d'interconnexion à géométrie variable, notamment du type MID (« Molded In Device »). La fixation de l'unité de commande est fixé audit substrat via les connextions électriques. Celles-ci peuvent être effectuées par soudage ou par collage, notamment avec une colle conductrice, par exemple à base d'argent.

Ledit système pourra en outre comprendre un dissipateur thermique, ladite carte étant située entre ledit substrat et ledit dissipateur.

Si l'on se reporte de nouveau à la figure 1, on constate que ledit système pourra comprendre en outre une optique 6 de mise en forme. Ladite optique 6 est destinée, par exemple, à réduire la divergence du faisceau émis par la ou les zones remplissant la fonction liseuse, voire la fonction d'éclairage de zones précises telles que vide-poche et/ou passage de porte. Elle pourra aussi être destinée, cumulativement ou alternativement, à former un diffuseur du faisceau émis par la ou les zones remplissant la fonction d'éclairage d'ambiance. Elle comprend pour cela un ou plusieurs composants optiques.

Suivant la deuxième variante de l'invention, ladite optique de mise en forme comprend une ou plusieurs lentilles d'un premier type, configurées pour maitriser la divergence du faisceau pour la fonction ambiance pour ne pas perdre de la lumière au-delà du cône à éclairer, par exemple pour éviter de perdre de la lumière au travers des vitres latérales. Elle pourra encore comprendre une ou plusieurs lentilles d'un second type, notamment des lentilles grand angle, destinées à élargir le faisceau émis pour atteindre une partie de l'habitacle à éclairer. Elle pourra encore comprendre des éléments optiques à champ réduit de projection pour la fonction liseuse tels qu'une ou plusieurs lentilles focalisées pour générer un faisceau d'ouverture réduite, notamment de moins de 45° d'ouverture.

Chacune des lentilles pourra être associée à l'une et/ou l'autre desdites zones émettrices.

Ladite optique de mise en forme, en particulier la ou lesdites lentilles, est de préférence directement en contact avec lesdites sources lumineuses, sur une partie ou la totalité de la ou desdites zones émettrices, en particulier avec une extrémité distale desdits bâtonnets.

Selon un aspect de l'invention, ledit système comprend en outre des sources configurées pour émettre des rayons présentant une longueur d'onde dans un domaine non-visible, en particulier l'infrarouge ou l'ultraviolet.

Lesdites sources configurées pour émettre des rayons présentant une longueur d'onde dans un domaine non-visible sont disposées, par exemple, sur ledit substrat. Il s'agit, notamment, de bâtonnets électroluminescents, par exemple issus dudit substrat, munies d'un convertisseur de longueur d'onde.

Le système pourra comprend en outre une unité de suivi des occupants du véhicule, configurée pour exploiter des informations recueillies à l'aide des rayons émis par la ou lesdites sources émettant des rayons présentant une longueur d'onde dans le domaine non-visible. Ladite unité de commande est configurée pour alimenter la ou lesdites zones en fonction d'informations, notamment des informations recueillies par ladite unité de suivi des occupants du véhicule, par exemple de la présence des occupants dans la zone à éclairer.

## Revendications

1. Système d'éclairage pour habitacle de véhicule automobile comprenant des sources lumineuses (2) électroluminescentes à semi-conducteur et un substrat (4) desdites sources lumineuses (2), ledit système d'éclairage réalisant les fonctions d'éclairage d'ambiance et/ou de liseuse dans l'habitacle du véhicule, lesdites sources lumineuses définissant une pluralité de zones émettrices de lumière (Sa, Slg, Sld), ledit système étant configuré pour activer la ou les sources lumineuses (2) d'une même zone indépendamment d'une zone à l'autre, ladite pluralité de zones (Sa, Slg, Sld) étant configurée pour émettre des faisceaux destinés à produire un éclairage différent d'une zone à l'autre, lesdites sources lumineuses (2) étant issues d'un seul et même substrat assurant les fonctions d'éclairage d'ambiance et/ou de liseuse, **caractérisé en ce que** le substrat (4) est un substrat de croissance, les sources sont reparties sur un seul substrat pour définir une pluralité de zones ; les sources comprennent des bâtonnets électroluminescents de dimensions submillimétriques s'étendant à partir dudit substrat (4), le système d'éclairage étant en outre **caractérisé en ce que** lesdits bâtonnets présentent une densité d'implantation différente d'une zone à l'autre ; et/ou, il comprend une optique (6) de mise en forme comprenant des lentilles d'un premier type pour élargir le faisceau émis et d'un second type pour générer un faisceau d'ouverture réduite, chacune des lentilles étant associée à l'une des zones émettrices.

2. Système d'éclairage selon l'une quelconque des revendications précédentes dans lequel l'une au moins desdites zones (Sa, Slg, Sld) comprend un convertisseur de longueur d'onde.

3. Système d'éclairage selon l'une quelconque des revendications précédentes dans lequel ledit système est configuré pour alimenter en courant la ou les sources lumineuse (2) d'une même zone indépendamment d'une autre desdites zones (Sa, Slg, Sld).

4. Système d'éclairage selon l'une quelconque des revendications précédentes dans lequel ledit système est configuré pour que la ou les sources lumineuses (2) d'au moins une même zone soient alimentées sélectivement avec au moins deux courants électriques d'intensité différente.

5. Système d'éclairage selon l'une quelconque des revendications 2 ou 3 dans lequel ledit système comprend une unité de commande, configurée pour contrôler l'alimentation en courant desdites zones (Sa, Slg, Sld).

6. Système d'éclairage selon la revendication précédente, dans lequel au moins une partie de l'unité de commande est empilée sous le substrat (4) de manière à connecter électriquement ladite unité de commande audit substrat (4).

7. Système d'éclairage selon l'une quelconque des revendications 5 ou 6 dans lequel ladite unité de commande comprend une carte à circuits imprimés.

8. Système d'éclairage selon la revendication précédente dans lequel ladite carte est disposée sur une face dudit substrat (4) opposée à une face portant lesdites sources lumineuses (2).

9. Système d'éclairage selon l'une quelconque des revendications précédentes dans lequel ledit système comprend en outre des sources configurées pour émettre des rayons présentant une longueur d'onde dans un domaine non-visible.

10. Système d'éclairage selon la revendication précédente dans lequel lesdites sources configurées pour émettre des rayons présentant une longueur d'onde dans un domaine non-visible sont disposées sur ledit substrat (4).

11. Système d'éclairage selon la revendication précédente dans lequel lesdites sources lumineuses configurées pour émettre des rayons présentant une longueur d'onde dans un domaine non-visible comprennent des bâtonnets électroluminescents munis d'au moins un convertisseur de longueur d'onde.

12. Système d'éclairage selon la revendication précédente dans lequel lesdits bâtonnets des sources lumineuses configurées pour émettre des rayons présentant une longueur d'onde dans un domaine non-visible sont issus dudit substrat (4).

13. Système d'éclairage selon l'une quelconque des revendications précédentes dans lequel ledit système comprend en outre une optique (6) de mise en forme.

14. Système d'éclairage selon la revendication précédente dans lequel ladite optique (6) de mise en forme comprend une ou plusieurs lentilles focalisées pour générer un faisceau d'ouverture réduite et/ou une ou plusieurs lentilles grand angle.

15. Système d'éclairage selon la revendication précédente dans lequel ladite optique (6) de mise en forme est directement en contact avec lesdites sources lumineuses (2).

## Patentansprüche

1. Beleuchtungssystem für einen Kraftfahrzeuginnenraum, das elektrolumineszente Halbleiter-Lichtquellen (2) und ein Substrat (4) der Lichtquellen (2) umfasst, wobei das Beleuchtungssystem die Ambiente- und/oder Leseleuchte-Beleuchtungsfunktionen in dem Innenraum des Fahrzeugs ausführt, wobei die Lichtquellen eine Mehrzahl von lichtemittierenden Zonen (Sa, Slg, Sld) definieren, wobei das System dazu ausgestaltet ist, die Lichtquelle(n) (2) einer selben Zone unabhängig von einer Zone zur anderen zu aktivieren, wobei die Mehrzahl von Zonen (Sa, Slg, Sld) dazu ausgestaltet ist, Bündel zu emittieren, die dazu bestimmt sind, eine von einer Zone zur anderen unterschiedliche Beleuchtung zu erzeugen, wobei die Lichtquellen (2) aus ein und demselben Substrat hervorgegangen sind, das die Ambiente- und/oder Leseleuchte-Beleuchtungsfunktionen gewährleistet, **dadurch gekennzeichnet, dass** das Substrat (4) ein Wachstumssubstrat ist, die Quellen auf einem einzigen Substrat verteilt sind, um eine Mehrzahl von Zonen zu definieren; die Quellen elektrolumineszente Stäbchen mit submillimetrischen Abmessungen umfassen, die sich ausgehend von dem Substrat (4) erstrecken, wobei das Beleuchtungssystem ferner **dadurch gekennzeichnet ist, dass** die Stäbchen eine von einer Zone zur anderen unterschiedliche Anordnungsdichte aufweisen; und/oder es eine Formgebungsoptik (6) umfasst, die Linsen eines ersten Typs zum Verbreitern des emittierten Bündels und eines zweiten Typs zum Generieren eines Bündels mit reduzierter Öffnung umfasst, wobei jede der Linsen einer der emittierenden Zonen zugeordnet ist.

2. Beleuchtungssystem nach einem der vorhergehenden Ansprüche, wobei mindestens eine der Zonen (Sa, Slg, Sld) einen Wellenlängenkonverter umfasst.

3. Beleuchtungssystem nach einem der vorhergehenden Ansprüche, wobei das System dazu ausgestaltet ist, die Lichtquelle(n) (2) einer selben Zone unabhängig von einer anderen der Zonen (Sa, Slg, Sld) mit Strom zu versorgen.

4. Beleuchtungssystem nach einem der vorhergehenden Ansprüche, wobei das System dazu ausgestaltet ist, dass die Lichtquelle(n) (2) mindestens einer selben Zone selektiv mit mindestens zwei elektrischen Strömen unterschiedlicher Stärke versorgt werden.

5. Beleuchtungssystem nach einem der Ansprüche 2 oder 3, wobei das System eine Steuerungseinheit umfasst, die dazu ausgestaltet ist, die Stromversorgung der Zonen (Sa, Slg, Sld) zu steuern.

6. Beleuchtungssystem nach dem vorhergehenden Anspruch, wobei mindestens ein Teil der Steuerungseinheit unter dem Substrat (4) gestapelt ist, so dass die Steuerungseinheit mit dem Substrat (4) elektrisch verbunden ist.

7. Beleuchtungssystem nach einem der Ansprüche 5 oder 6, wobei die Steuerungseinheit eine Leiterplatte umfasst.

8. Beleuchtungssystem nach dem vorhergehenden Anspruch, wobei die Platte auf einer Seite des Substrats (4) angeordnet ist, die zu einer die Lichtquellen (2) tragenden Seite entgegengesetzt ist.

9. Beleuchtungssystem nach einem der vorhergehenden Ansprüche, wobei das System ferner Quellen umfasst, die dazu ausgestaltet sind, Strahlen zu emittieren, die eine Wellenlänge in einem nicht-sichtbaren Bereich aufweisen.

10. Beleuchtungssystem nach dem vorhergehenden Anspruch, wobei die Quellen, die dazu ausgestaltet sind, Strahlen zu emittieren, die eine Wellenlänge in einem nicht-sichtbaren Bereich aufweisen, auf dem Substrat (4) angeordnet sind.

11. Beleuchtungssystem nach dem vorhergehenden Anspruch, wobei die Lichtquellen, die dazu ausgestaltet sind, Strahlen zu emittieren, die eine Wellenlänge in einem nicht-sichtbaren Bereich aufweisen, elektrolumineszente Stäbchen umfassen, die mit mindestens einem Wellenlängenkonverter versehen sind.

12. Beleuchtungssystem nach dem vorhergehenden Anspruch, wobei die Stäbchen der Lichtquellen, die dazu ausgestaltet sind, Strahlen zu emittieren, die eine Wellenlänge in einem nicht-sichtbaren Bereich aufweisen, aus dem Substrat (4) hervorgegangen sind.

13. Beleuchtungssystem nach einem der vorhergehenden Ansprüche, wobei das System ferner eine Formgebungsoptik (6) umfasst.

14. Beleuchtungssystem nach dem vorhergehenden Anspruch, wobei die Formgebungsoptik (6) eine oder mehrere fokussierte Linsen zum Generieren eines Bündels mit reduzierter Öffnung und/oder eine oder mehrere Weitwinkellinsen umfasst.

15. Beleuchtungssystem nach dem vorhergehenden Anspruch, wobei die Formgebungsoptik (6) mit den Lichtquellen (2) direkt in Kontakt ist.

## Claims

1. Lighting system for a passenger compartment of a motor vehicle, said lighting system comprising semiconductor-based electroluminescent light sources (2) and a substrate (4) of said light sources (2), said lighting system performing an ambient-lighting function and/or reading-light function in the passenger compartment of the vehicle, said light sources defining a plurality of light-emitting zones (Sa, Slg, Sld), said system being configured to activate the one or more light sources (2) of a given zone independently from one zone to another, said plurality of zones (Sa, Slg, Sld) being configured to emit beams that are intended to produce lighting that differs from one zone to another, said light sources (2) emanating from one and the same substrate performing the ambient-lighting function and/or reading-light function, **characterized in that** the substrate (4) is a growth substrate, the sources are distributed over a single substrate to define a plurality of zones, and the sources comprise light-emitting rods of submillimetre dimensions extending from said substrate (4), the lighting system further being **characterized in that** said rods have a site density that differs from one zone to another, and/or it comprises a shaping optical device (6) comprising lenses of a first type for widening the emitted beam and of a second type for generating a beam of small aperture, each of the lenses being associated with one of the emitting zones.

2. Lighting system according to any one of the preceding claims, wherein at least one of said zones (Sa, Slg, Sld) comprises a wavelength converter.

3. Lighting system according to any one of the preceding claims, wherein said system is configured to supply current to the one or more light sources (2) of a given zone independently of another of said zones (Sa, Slg, Sid).

4. Lighting system according to any one of the preceding claims, wherein said system is configured so that the one or more light sources (2) of at least one given zone are selectively supplied with at least two electric currents of different amplitude.

5. Lighting system according to either one of Claims 2 and 3, wherein said system comprises a control unit configured to control the supply of current to said zones (Sa, Slg, Sid).

6. Lighting system according to the preceding claim, wherein at least part of the control unit is stacked under the substrate (4) so as to electrically connect said control unit to said substrate (4).

7. Lighting system according to either one of Claims 5 and 6, wherein said control unit comprises a printed circuit board.

8. Lighting system according to the preceding claim, wherein said board is placed on a side of said substrate (4) opposite a side bearing said light sources (2).

9. Lighting system according to any one of the preceding claims, wherein said system further comprises sources configured to emit rays having a wavelength in a non-visible domain.

10. Lighting system according to the preceding claim, wherein said sources configured to emit rays having a wavelength in a non-visible domain are placed on said substrate (4).

11. Lighting system according to the preceding claim, wherein said light sources configured to emit rays having a wavelength in a non-visible domain comprise electroluminescent rods provided with at least one wavelength converter.

12. Lighting system according to the preceding claim, wherein said rods of the light sources configured to emit rays having a wavelength in a non-visible domain emanate from said substrate (4).

13. Lighting system according to any one of the preceding claims, wherein said system further comprises a shaping optical device (6).

14. Lighting system according to the preceding claim, wherein said shaping optical device (6) comprises one or more lenses focused to generate a beam of small aperture and/or one or more wide-angle lenses.

15. Lighting system according to the preceding claim, wherein said shaping optical device (6) makes direct contact with said light sources (2).
